# EUROPÄISCHE PATENTSCHRIFT

(11) **EP 0 523 314 B1**
(45) Veröffentlichungstag und Bekanntmachung des Hinweises auf die Patenterteilung: **20.11.1996**
(21) Anmeldenummer: 92102919.5
(22) Anmeldetag: 21.02.1992
(51) Int. Cl.: C23C 16/44, C30B 25/14

(54) **Vorrichtung zur Verdampfung von Flüssigkeiten**
Apparatus for evaporation of liquid
Appareil pour l'évaporation d'un liquide

(30) Priorität: 19.07.1991 DE 4124018
(43) Veröffentlichungstag der Anmeldung: 20.01.1993
(73) Patentinhaber: Balzers und Leybold Deutschland Holding Aktiengesellschaft, 63450 Hanau (DE)
(72) Erfinder: Arnold, Manfred, Dr., W-7996 Meckenbeuren (DE); Gegenwart, Rainer, Dr., W-6074 Rödermark (DE); Noll, Sonja, 6-1, 4 Chome, Namiki, Tsukuba City (JP); Ritter, Jochen, W-6312 Laubach 1 (DE); Stoll, Helmut, W-6231 Sulzbach (DE)
(74) Vertreter: Sartorius, Peter, Dipl.-Ing.

(56) Entgegenhaltungen:
- EP-A- 0 361 171
- WO-A-87/07848
- US-A- 4 212 663
- US-A- 4 947 790
- PATENT ABSTRACTS OF JAPAN vol. 5, no. 67 (C-53)(739) 7. Mai 1981 & JP-A-5617946

## Beschreibung

Die Erfindung bezieht sich auf eine Vorrichtung zur Verdampfung von Flüssigkeiten, insbesondere Si-haltige Monomere, zur Herstellung von Silizium und/oder Sauerstoff enthaltenden, dünnen Schichten durch chemische Dampfabscheidung (CVD-Verfahren) im Vakuum auf Substraten unter Verwendung einer Strömungsstelleinrichtung und eines dieser nachgeschalteten Verdampfers.

In den Bereichen der Mikroelektronik, Displaytechnik und Sensorik kommen unter anderem dünne Schichten aus SiO₂, Si₃N₄, a-C:H, a-Si:C zur Anwendung. In bekannter Weise werden die Schichten im Niederdruck-, CVD- oder Plasma-Enhanced-CVD-Verfahren hergestellt. Als Ausgangsmaterialien für diese Schichten kommen die unterschiedlichsten Gase zum Einsatz, beispielsweise kann SiH₄ (Silan) verwendet werden. Für etliche Anwendungen sind auch Verbindungen geeignet, die erst in die Gasphase überführt werden müssen, da sie bei Raumtemperatur in flüssiger Form vorliegen und einen niedrigen Dampfdruck besitzen. Als Beispiel sind da TEOS = Tetraethoxysilan oder HMDS = Hexamethyldisilan zu nennen. Um die genannten Schichten mit diesen in die Gasphase überführten Flüssigkeiten reproduzierbar herzustellen, ist ein absolut konstanter, reproduzierbarer und regelbarer Gasfluß erforderlich. Hierzu kann etwa in bekannter Weise ein inertes Trägergas Ar, He oder N₂ durch die flüssige Verbindung geleitet werden. Durch Diffusion wird das Trägergas mit der Verbindung gesättigt, so daß diese nunmehr in den Reaktor geleitet werden kann. Die hierzu notwendige Regelung erfolgt durch Temperatur- und Trägergaskontrolle. Ein Nachteil dieser Methode ist die immer vorhandene große Menge an Trägergas, welches natürlich auch in den Reaktor geleitet wird und den Prozeß stört oder das Prozeßfenster verkleinert. Außerdem ist eine sehr genaue und aufwendige Temperaturkontrolle notwendig, da die Trägergasbeladung direkt von der Temperatur abhängt.

Es ist ferner bekannt, die flüssige Verbindung in einem geheizten Vorratsbehälter aufzunehmen. Der Dampf oberhalb der Flüssigkeit wird ebenfalls mittels eines beheizten Flüssigkeitskontrollers in einen Reaktor geleitet. Die Beheizung des Flüssigkeitskontrollers ist ebenfalls sehr aufwendig.

Außerdem ist aus der US-A-4 212 663 bereits eine Vorrichtung zur Erzeugung von Dampf unter Verwendung eines ersten und zweiten Verdampferkörpers bekannt, der in einem zylindrischen Gehäuse untergebracht ist. Diese Vorrichtung wird über einen Behälter mit Trägergas beschickt, das über eine Flüssigkeit von unten dem zylinderförmigen Gehäuse zugeführt wird. Das durch die Flüssigkeit hindurch diffundierte Gas wird von einer Packung hydrolysiert und dann über eine weitere Packung über eine Leitung einem Glaselement zugeführt. Ferner wird über eine Pumpe und eine Leitung Flüssigkeit gegen einen Reflektor geleitet, so daß die Flüssigkeit dann über den Verdampfer geführt werden kann. Aus Vorstehendem ergibt sich, daß eine derartige Vorrichtung ohne Trägergas nicht funktionieren kann.

Ferner ist aus der US-A-4 947 790 eine Vorrichtung zur Erzeugung eines Gasflusses bekannt, bei der ein gasförmiges Medium eingesetzt wird und ein pulverförmiges Mittel in einem zylinderförmigen Körper vorgesehen ist, mit der die erfindungsgemäße Wirkung, die Verdampfungszeit der Flüssigkeit herabzusetzen, nicht erzielt werden kann.

Ferner ist bereits eine Vorrichtung sowie ein Verfahren der eingangs aufgeführten Art bekannt (EP 0 361 171 A1), das zum Verdampfen von bei Raumtemperatur flüssigen Monomeren dient. Zur Herstellung von Silizium und Sauerstoff enthaltenden, dünnen Schichten wird hierzu die chemische Dampfabscheidung eingesetzt. Hierzu ist es ferner bekannt, als Strömungsstelleinrichtung einen Massendurchflußregler einzusetzen, wobei das von diesem geförderte Monomer in flüssigem Zustand dem Verdampfer zugeführt wird. Bei diesem bekannten Verfahren ist die umgesetzte Flußmenge stark begrenzt, da bei höheren Durchflußmengen von über 25 g/h kein stabiler Fluß mehr zu erzeugen ist. Aus diesem Grund ist mit dem bekannten Verfahren keine sichere Prozeßführung möglich. Außerdem weist die bekannte Vorrichtung eine sehr kleine Oberfläche auf, so daß der gesamte Wirkungsgrad der Vorrichtung äußerst ungünstig ist.

Demgemäß besteht die Erfindungsaufgabe darin, eine Vorrichtung zu schaffen, mit der auf einfache und wirtschaftliche Weise eine einwandfreie Verdampfung der Flüssigkeit bei Verbesserung des Wirkungsgrads erreicht wird.

Gelöst wird die Aufgabe erfindungsgemäß dadurch, daß das Gehäuse des Verdampfers über einen Verdampferkörper in einen Einlaßraum für die zu verdampfende Flüssigkeit und einen Auslaßraum unterteilt wird, so daß die Flüssigkeit nur über den flüssigkeitsdurchlässig ausgebildeten Verdampferkörper geleitet wird und der Verdampferkörper über einen Ultraschallzerstäuber mit zerstäubter Flüssigkeit versorgt wird.

In weiterer Ausgestaltung der Erfindung ist es vorteilhaft, daß der gesamte Verdampferkörper porös bzw. zumindest teilweise durchlässig ausgebildet ist und daß die Oberfläche des Verdampferkörpers aufgerauht ist. Durch die Aufrauhung wird auf einfache Weise die Gesamtoberfläche des Verdampfers vergrößert und dadurch die Verdampfungszeit der Flüssigkeit wesentlich herabgesetzt.

Hierzu ist es vorteilhaft, daß der Verdampferkörper zwischen dem Ultraschallzerstäuber und der Auslaßöffnung des Gehäuses vorgesehen und der Ultraschallzerstäuber mit einer Membrane ausgerüstet ist, die mittels eines Oszillators mit Mittelfrequenz oder auch entsprechend der Flüssigkeit mit einer anderen geeigneten Frequenz zum Schwingen gebracht wird. Hierdurch kann die in einem Vorratsbehälter vorgesehene Flüssigkeit über eine Strömungsstelleinrichtung bzw. Dosiervorrichtung dem Ultraschallzerstäuber dosiert zugeführt werden. Der Flüssigkeitsstrom, der durch die Düse des Ultraschallzerstäubers tritt, wird durch die Schwingungen der Membrane in viele kleine Tröpfchen der Größenordnung zwischen 50 und 100 µm zerstäubt. Diese Tröpfchen treffen auf den im Gehäuse des Verdampfers vorgesehenen Verdampferkörper auf, so daß in kürzester Zeit eine Verdampfung der Flüssigkeit erfolgt.

In weiterer Ausgestaltung der Erfindung ist es vorteilhaft, daß der Verdampferkörper die gesamte Querschnittsfläche des Gehäuses des Verdampfers einnimmt und aus einem offenporigen Sintermaterial hergestellt ist. Hierdurch wird auf einfache Weise eine sehr große Oberfläche ohne Volumenvergrößerung des Verdampferkörpers geschaffen.

Außerdem ist es vorteilhaft, daß der Verdampferkörper in Richtung des Ultraschallzerstäubers zeigende, mit Bezug auf die Längsmittelachse des Gehäuses geneigt verlaufende Oberflächen aufweist.

Gemäß einem besonderen Merkmal der erfindungsgemäßen Lösung ist schließlich vorgesehen, daß der Verdampferkörper konkav oder konvex pyramidenstumpfförmig ausgebildet ist.

Von besonderer Bedeutung ist für die vorliegende Erfindung, daß das Gehäuse des Verdampferkörpers und/oder der Innenraum und/oder der Ultraschallzerstäuber mittels einer Heizung beheizbar ist, die mit einer Temperaturregelvorrichtung in Wirkverbindung steht.

Ferner ist es vorteilhaft, daß das Gehäuse zur Aufnahme des Verdampferkörpers an eine Vakuumpumpe angeschlossen ist.

Die Erzeugung vieler kleiner Tropfen ist von großem Vorteil, da hierdurch auf einfache Weise die Oberfläche der Flüssigkeit vergrößert werden kann. Der aus Sintermetall hergestellte Verdampferkörper homogenisiert den Flüssigkeits- bzw. Dampffluß.

Weitere Merkmale der Erfindung sind in den Unteransprüchen, in der Beschreibung und in den Figuren beschrieben bzw. dargestellt, wobei bemerkt wird, daß alle Einzelmerkmale und alle Kombinationen von Einzelmerkmalen erfindungswesentlich sind.

In der nachfolgenden Figur ist die Erfindung an einer Ausführungsform beispielsweise dargestellt, ohne auf diese Ausführungsform beschränkt zu sein.

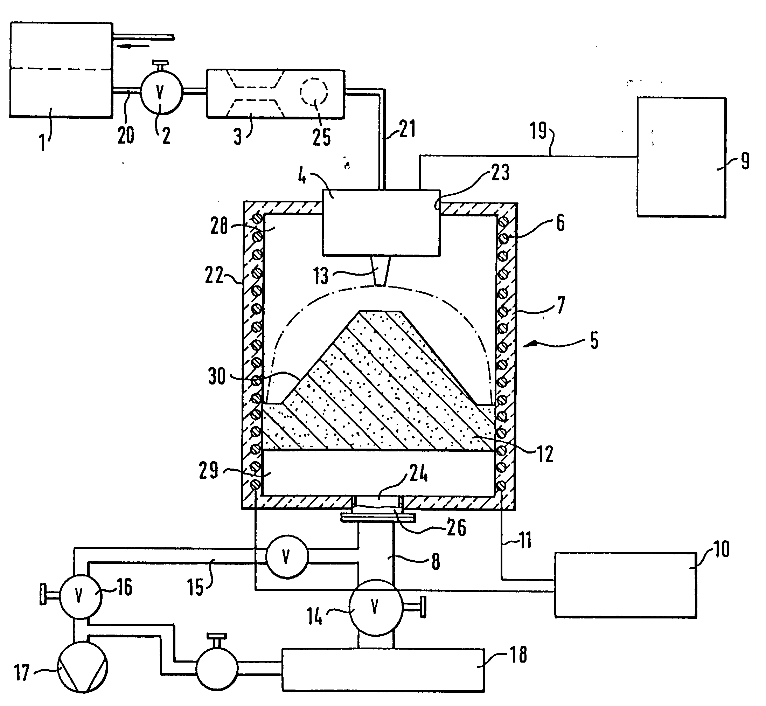

In der Zeichnung ist mit 1 ein Vorratsbehälter bezeichnet, der über eine Versorgungsleitung 20 mit einem Flüssigkeitskontroller 3 verbunden ist. Zwischen dem Vorratsbehälter 1 und dem Flüssigkeitskontroller bzw. der Strömungsstelleinrichtung 3 befindet sich ein Sperrventil 2, so daß der Vorratsbehälter 1 im Bedarfsfall zugeschaltet werden kann.

Der Flüssigkeitskontroller 3 steht über eine weitere Versorgungsleitung 21 mit einem Verdampfer 5 in Verbindung. Der Flüssigkeitskontroller 3 kann mit einer in der Zeichnung nicht dargestellten Regeleinrichtung in Verbindung stehen, die die Flüssigkeitszufuhr aus dem Vorratsbehälter 1 regelt.

Der Verdampfer 5 besteht aus einem Gehäuse 22, das in einem Bereich eine Einlaßöffnung 23 und in einem anderen Bereich eine Auslaßöffnung 24 aufweist.

Der Verdampfer 5 ist ringsum von einer Heizung 6 umgeben, die als Heizspirale ausgebildet sein kann und den Verdampfer 5 auf der notwendigen Betriebstemperatur hält.

Ferner ist der Verdampfer 5 und somit die Heizung 6 vollständig von einer Isolierung 7 umgeben. In vorteilhafter Weise steht die Heizung über eine elektrische Leitung 11 mit einer Temperaturregeleinrichtung 10 in Verbindung, so daß die Heizung zwischen einer Temperatur von beispielsweise 50 bis 200 °C geregelt werden kann.

In der Einlaßöffung 23 befindet sich der Ultraschallzerstäuber 4, der über eine elektrische Leitung 19 mit einem Oszillator 9 in Verbindung steht, der eine in der Zeichnung nicht dargestellte Membrane des Ultraschallzerstäubers 4 in Schwingung versetzt.

Im unteren Bereich des Gehäuses 22 befindet sich die Auslaßöffnung 24, in der ein Auslaßstutzen 26 vorgesehen ist, der über eine Leitung 8 und ein einstellbares Ventil 14 mit dem in der Zeichnung nur schematisch dargestellten Reaktor 18 der zu beschichtenden Teile verbunden ist.

Innerhalb des Gehäuses 22 des Verdampfers 5 befindet sich ein Verdampferkörper 12, der aus einem porösen Werkstoff besteht, so daß man eine sehr große Oberfläche erhält. In vorteilhafter Weise kann der Verdampferkörper 12 aus einem Sintermaterial, insbesondere aus Sinterbronze, bestehen, die eine Porenweite zwischen 1 und 200 µm aufweisen kann. Es kann auch ein anderes Material verwendet werden, das aufgrund seiner Oberflächenbeschaffenheit eine große Oberfläche ergibt.

Das erfindungsgemäße Verfahren zur Abscheidung von Si und/oder Si-haltigen Verbindungen und die hierzu einsetzbare Vorrichtung ist nachfolgend beschrieben.

Zuerst wird eine Flüssigkeit in den Vorratsbehälter 1 eingefüllt, danach in den Vorratsbehälter 1 ein inertes Gas, wie z. B. Ar, He, N₂, eingebracht, das die Flüssigkeit mit einem Druck von z. B. 1 bar überlagert. Wie aus der Zeichnung hervorgeht, wird dann die Flüssigkeit über die Leitung 20 und den Flüssigkeitskontroller bzw. eine Dosiereinrichtung 3 dem Ultraschallzerstäuber 4 zugeführt. Der Ultraschallzerstäuber 4 ist mit einer Düse 13 ausgerüstet, die eine in der Zeichnung nicht dargestellte Membrane aufweist, die die Flüssigkeit zerstäubt. Die Membrane wird hierzu mittels des Oszillators 9 mit Mittelfrequenz zum Schwingen gebracht. Auf diese Weise wird der Flüssigkeitsstrom, der durch die Düse 13 geleitet wird, zum Schwingen gebracht und in viele kleine Tröpfchen in einer Größenordnung zwischen 50 und 100 µm zerstäubt. Diese Tröpfchen treffen dann auf den geheizten Verdampferkörper 12, der aus einem Sintermaterial oder aus einem anderen Material mit relativ großer Oberfläche bestehen kann. Der Verdampferkörper 12 kann in vorteilhafter Weise eine Porenoberfläche zwischen 1 und 200 µm aufweisen. Die auf diese Weise erzeugte Tropfenbildung der Flüssigkeit hat ganz erhebliche Vorteile, da viele kleine Tröpfchen bei gleichem Volumen eine relativ große Oberfläche bilden, d. h. je mehr Tropfen gebildet werden können, desto größer wird die Oberfläche der Flüssigkeit. Die Oberfläche der Flüssigkeit ist sehr entscheidend für die Wärmeübertragung und somit auch für die Verdampfung der Flüssigkeit.

Da ein kleiner Tropfen schneller verdampft als ein großer, läßt sich hierdurch die Verdampfungszeit der Flüssigkeit sehr stark reduzieren. Auf einfache Weise erreicht man auch durch die Zerstäubung einen konstanten Flüssigkeitsfluß.

Durch den Einsatz unterschiedlich ausgebildeter und dimensionierter Ultraschallzerstäuber und Verdampfergrößen kann jeder gewünschte Fluß eingestellt werden.

Die vom Ultraschallzerstäuber 4 zerstäubte Flüssigkeit gelangt, wie bereits ausgeführt, auf den Verdampferkörper 12, der die Verdampfung der noch nicht verdampften Flüssigkeit bewirkt. Da durch den Verdampfungsvorgang die im Gehäuse 22 herrschende Temperatur stark herabgesetzt wird, ist es vorteilhaft, wenn hierzu der Verdampfer 5 mittels der Heizung 6 insgesamt aufgeheizt wird.

Bei diesem Arbeitsverfahren wird die Temperaturregelung mittels der Temperaturregeleinrichtung 10 durchgeführt, die über die elektrische Leitung 11 mit der elektrischen Heizung 6 in Wirkverbindung steht. Hierdurch wird sichergestellt, daß die Wärmezufuhr zum Verdampferkörper 12 über die Gehäusewand erfolgt. Ferner ist es auch möglich, eine Heizung im Innenraum des Gehäuses 22 des Wärmetauschers vorzusehen.

Durch das erfindungsgemäße Verfahren und die zugehörige Vorrichtung erhält man eine sehr homogene, schnelle Verdampfung im Vakuum, ohne daß Druckschwankungen oder Druckstöße durch Siedeverzugeffekte auftreten.

Das Gehäuse 22 zur Aufnahme des Verdampferkörpers 12 ist über die an den Auslaßstutzen 26 angeschlossene Leitung 8 und über ein einstellbares Ventil 14 mit dem Reaktor 18 und über eine weitere Leitung 15 und ein zweites Ventil 16 mit einer Vakuumpumpe 17 verbunden.

Damit sichergestellt ist, daß die Flüssigkeit vom Vorratsbehälter 1 zum Reaktor 18 nur über den Verdampferkörper 12 gelangt, ist der Verdampferkörper 12 des Gehäuses 22 in zwei Abschnitte unterteilt, und zwar in einen Einlaßraum 28 und einen Auslaßraum 29, die durch den Verdampferkörper 12 vollständig getrennt sind.

Wie bereits beschrieben, besteht der Verdampferkörper 12 beispielsweise aus einem Sintermaterial, das derart durchlässig beschaffen ist, daß die Flüssigkeit von dem Einlaßraum 28 zum Auslaßraum 29 gelangen kann. Hierdurch erhält man mit einfachen baulichen Mitteln eine relativ große Oberfläche auf dem Verdampferkörper 12. Ferner kann der Verdampferkörper 12 pyramidenstumpf-, kegel- oder dachförmig ausgebildet sein.

### Bezugszeichenliste

- 1: Vorratsbehälter
- 2: Sperrventil
- 3: Flüssigkeitskontroller, Dosiereinrichtung= Strömungsstelleinrichtung
- 4: Ultraschallzerstäuber
- 5: Verdampfer
- 6: Heizung
- 7: Isolierung
- 8: Leitung
- 9: Oszillator
- 10: Temperaturregeleinrichtung
- 11: Leitung
- 12: Verdampferkörper
- 13: Düse
- 14: Ventil
- 15: Leitung
- 16: Ventil
- 17: Vakuumpumpe
- 18: Reaktor
- 19: Leitung
- 20: Versorgungsleitung
- 21: Versorgungsleitung
- 22: Gehäuse
- 23: Einlaßöffnung
- 24: Auslaßöffnung
- 25: Regelventil
- 26: Auslaßstutzen
- 28: Einlaßraum
- 29: Auslaßraum
- 30: Oberfläche

## Patentansprüche

1. Vorrichtung zur Verdampfung von Flüssigkeiten, insbesondere Monomere, zur Herstellung von Silizium und/oder Sauerstoff enthaltenden, dünnen Schichten durch chemische Dampfabscheidung (CVD-Verfahren, PECVD) im Vakuum auf Substraten unter Verwendung einer Strömungsstelleinrichtung und eines dieser nachgeschalteten Verdampfers, **dadurch gekennzeichnet**, daß das Gehäuse (22) des Verdampfers (5) über einen Verdampferkörper (12) in einen Einlaßraum (28) für die zu verdampfende Flüssigkeit und einen Auslaßraum (29) unterteilt wird, so daß die Flüssigkeit nur über den flüssigkeitsdurchlässig ausgebildeten Verdampferkörper (12) geleitet wird und der Verdampferkörper (12) über einen Ultraschallzerstäuber (4) mit zerstäubter Flüssigkeit versorgt wird.

2. Vorrichtung nach Anspruch 1, **dadurch gekennzeichnet**, daß der gesamte Verdampferkörper (12) porös bzw. zumindest teilweise durchlässig ausgebildet ist.

3. Vorrichtung nach Anspruch 1, **dadurch gekennzeichnet**, daß die Oberfläche des Verdampferkörpers (12) aufgerauht ist.

4. Vorrichtung nach Anspruch 1, **dadurch gekennzeichnet**, daß der Verdampferkörper (12) zwischen dem Ultraschallzerstäuber (4) und der Auslaßöffnung des Gehäuses (22) vorgesehen ist.

5. Vorrichtung nach Anspruch 1 oder 2, **dadurch gekennzeichnet**, daß der Verdampferkörper (12) die gesamte Querschnittsfläche des Gehäuses (22) des Verdampfers (5) einnimmt.

6. Vorrichtung nach einem oder mehreren der vorhergehenden Ansprüche, **dadurch gekennzeichnet**, daß der Verdampferkörper (12) aus einem offenporigen Sintermaterial hergestellt ist.

7. Vorrichtung nach einem oder mehreren der vorhergehenden Ansprüche, **dadurch gekennzeichnet**, daß der Verdampferkörper (12) in Richtung des Ultraschallzerstäubers (4) zeigende, mit Bezug auf die Längsmittelachse des Gehäuses (22) geneigt verlaufende Oberflächen (30) aufweist.

8. Vorrichtung nach einem oder mehreren der vorhergehenden Ansprüche, **dadurch gekennzeichnet**, daß der Verdampferkörper (12) konkav oder konvex pyramidenstumpfförmig ausgebildet ist.

9. Vorrichtung nach einem oder mehreren der vorhergehenden Ansprüche, **dadurch gekennzeichnet**, daß das Gehäuse (22) des Verdampferkörpers (12) und/oder der Innenraum und/oder der Ultraschallzerstäuber (4) mittels einer Heizung (6) beheizbar ist, die mit einer Temperaturregelvorrichtung (10) in Wirkverbindung steht.

10. Vorrichtung nach einem oder mehreren der vorhergehenden Ansprüche, **dadurch gekennzeichnet**, daß das Gehäuse (22) zur Aufnahme des Verdampferkörpers (12) an eine Vakuumpumpe (17) angeschlossen ist.

## Claims

1. Apparatus for the evaporation of liquids, especially monomers, for the preparation of thin layers containing silicon and/or oxygen by chemical vapor deposition (CVD process, PECVD) *in vacuo* onto substrates with the use of a flow adjusting device and an evaporator connected to its output, **characterized in that** the housing (22) of the evaporator (5) is divided by an evaporator body (12) into an inlet chamber (28) for the liquid to be evaporated and into an outlet chamber (29) such that the liquid passes only through the liquid-permeable evaporator body (12), and the evaporator body (12) is provided with atomized liquid by an ultrasonic atomizer (4).

2. Apparatus according to claim 1, **characterized in that** the entire evaporator body (12) is made to be porous or at least partially permeable.

3. Apparatus according to claim 1, **characterized in that** the surface of the evaporator body (12) is roughened.

4. Apparatus according to claim 1, **characterized in that** the evaporator body (12) is situated between the ultrasonic atomizer (4) and the outlet opening of the housing (22).

5. Apparatus according to claim 1 or 2, **characterized in that** the evaporator body (12) occupies the entire cross-sectional area of the housing (22) of the evaporator (5).

6. Apparatus according to one or more of the foregoing claims, **characterized in that** the evaporator body (12) is made of an open-pored sintered material.

7. Apparatus according to one or more of the foregoing claims, **characterized in that** the evaporator body (12) has surfaces (30) pointing in the direction of the ultrasonic atomizer (4) with respect to the longitudinal central axis of the housing (22).

8. Apparatus according to one or more of the foregoing claims, **characterized in that** the evaporator body (12) is in the form of a truncated pyramid (concave or convex).

9. Apparatus according to one or more of the foregoing claims, **characterized in that** the housing (22) of the evaporator body (12) and/or the inner chamber and/or the ultrasonic atomizer (4) can be heated by means of a heater (6) which is in working association with a temperature control system (10).

10. Apparatus according to one or more of the foregoing claims, **characterized in that** the housing (22) for the accommodation of the evaporator body (12) is connected to a vacuum pump (17).

## Revendications

1. Appareil pour l'évaporation de liquides, notamment de monomères, destiné à la réalisation de couches minces contenant du silicium et/ou de l'oxygène par séparation de vapeur par voie chimique (procédé CVD, PECVD) sous vide sur des substrats, en ayant recours à un dispositif de réglage du flux et à un évaporateur en aval dudit régulateur du flux, **caractérisé en ce que** l'enceinte (22) de l'évaporateur (5) est subdivisée par l'intermédiaire d'un corps d'évaporateur (12) en un espace d'admission (28) du liquide devant être évaporé et en un space de sortie (29), de manière à ce que le liquide s'écoule uniquement en passant par le corps d'évaporateur (12) perméable aux liquides, et que le corps d'évaporateur (12) est alimenté en liquide pulvérisé par un atomiseur par ultrasons (4).

2. Dispositif selon la revendication 1, **caractérisé en ce que** le corps d'évaporateur (12) est entièrement poreux ou tout au moins partiellement perméable.

3. Dispositif selon la revendication 1, **caractérisé en ce que** le corps d'évaporateur (12) présente un grainage de surface.

4. Dispositif selon la revendication 1, **caractérisé en ce que** le corps d'évaporateur (12) est disposé entre l'atomiseur par ultrasons (4) et l'ouverture de sortie de l'enceinte (22).

5. Dispositif selon l'une des revendications 1 ou 2, **caractérisé en ce que** le corps d'évaporateur (12) occupe toute la section de l'enceinte (22) de l'évaporateur (5).

6. Dispositif selon l'une quelconque ou plusieurs des revendications ci-avant, **caractérisé en ce que** le corps d'évaporateur (12) est fabriqué en un matériau fritté à pores ouverts.

7. Dispositif selon l'une ou plusieurs des revendications ci-avant, **caractérisé en ce que** le corps d'évaporateur (12) présente des surfaces (30) dirigées vers l'atomiseur par ultrasons (4) et inclinées par rapport à l'axe médian longitudinal de l'enceinte (22).

8. Dispositif selon l'une quelconque ou plusieurs des revendications ci-avant, **caractérisé en ce que** le corps d'évaporateur (12) est en forme de pyramide tronquée concave ou convexe.

9. Dispositif selon l'une quelconque ou plusieurs des revendications ci-avant, **caractérisé en ce que** l'enceinte (22) du corps d'évaporateur (12) et/ou l'espace intérieur et/ou l'atomiseur par ultrasons (4) sont chauffés par un chauffage (6) qui est en corrélation avec un thermorégulateur (10).

10. Dispositif selon l'une quelconque ou plusieurs des revendications ci-avant, **caractérisé en ce que** l'enceinte (22) dans laquelle est logé le corps d'évaporateur (12) est reliée à une pompe à vide (17).
